# EUROPEAN PATENT APPLICATION

(11) **EP 4 462 143 A1**
(43) Date of publication of application: **13.11.2024**
(21) Application number: 23816263.0
(22) Date of filing: 16.05.2023
(51) Int. Cl.: G01R 31/392, G01R 31/389, G01R 31/3835, G01R 29/02, G01R 19/10, G01R 31/378, H01M 10/052, B60L 58/16

(54) **BATTERY DIAGNOSIS APPARATUS AND METHOD**

(30) Priority: 30.05.2022 KR 20220066254
(71) Applicant: LG Energy Solution, Ltd., Seoul 07335 (KR)
(72) Inventor: KIM, Dae-Soo, Daejeon 34122 (KR); KIM, Young-Deok, Daejeon 34122 (KR)
(74) Representative: Goddar, Heinz J.
(86) International application number: PCT/KR2023/006643
(87) International publication number: WO 2023/234600

(57) **Abstract**

An apparatus for diagnosing a battery according to an embodiment of the present disclosure includes a voltage measuring unit configured to measure a voltage of a battery during a discharge process of the battery; a pulse output unit configured to generate a discharge pulse at every predetermined cycle and output the generated discharge pulse to the battery; and a control unit configured to calculate a resistance value of the battery based on a voltage deviation of the battery due to the discharge pulse, determine a resistance pattern in a preset initial discharge region based on the calculated resistance value, and diagnose whether there is lithium precipitation in the battery according to the determined resistance pattern.

## Description

### TECHNICAL FIELD

The present application claims priority to Korean Patent Application No. 10-2022-0066254 filed on May 30, 2022 in the Republic of Korea, the disclosures of which are incorporated herein by reference.

The present disclosure relates to an apparatus and method for diagnosing a battery, and more particularly, to an apparatus and method for diagnosing a battery, which is capable of diagnosing a battery state.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being done on these batteries in terms of increasing capacity and density, but improving lifespan and safety is also important. To achieve this, it is necessary to suppress the decomposition reaction with the electrolyte on the electrode surface and prevent overcharge and overdischarge.

In particular, it is necessary to prevent lithium precipitation on the surface of the negative electrode (lithium plating, Li-plating). When lithium precipitates on the surface of the negative electrode, it causes side reactions with the electrolyte and changes in the kinetic balance of the battery, causing battery deterioration. In addition, as lithium metal is precipitated on the surface of the negative electrode, an internal short circuit of the battery may occur, so there is a risk of ignition or explosion due to an internal short circuit. Therefore, there is a need to develop a technology that can detect whether lithium metal has been precipitated on the surface of the negative electrode.

### DISCLOSURE

### Technical Problem

The present disclosure is designed to solve the problems of the related art, and therefore the present disclosure is directed to providing an apparatus and method for diagnosing a battery, which is capable of diagnosing lithium precipitation in the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a voltage measuring unit configured to measure a voltage of a battery during a discharge process of the battery; a pulse output unit configured to generate a discharge pulse at every predetermined cycle and output the generated discharge pulse to the battery; and a control unit configured to calculate a resistance value of the battery based on a voltage deviation of the battery due to the discharge pulse, determine a resistance pattern in a preset initial discharge region based on the calculated resistance value, and diagnose whether there is lithium precipitation in the battery according to the determined resistance pattern.

The control unit may be configured to calculate a resistance change rate for a plurality of target resistance values included in the initial discharge region, compare the calculated resistance change rate with a preset criterion change rate, and determine the resistance pattern as a first resistance pattern or a second resistance pattern based on the comparison result.

The control unit may be configured to calculate an average change rate for the plurality of target resistance values included in the initial discharge region, and calculate the calculated average change rate as the resistance change rate.

The control unit may be configured to determine the resistance pattern as the first resistance pattern when the calculated resistance change rate is less than the criterion change rate.

The control unit may be configured to determine the resistance pattern as the second resistance pattern when the calculated resistance change rate is equal to or greater than the criterion change rate.

The control unit may be configured to diagnose that lithium has been precipitated in the battery when the resistance pattern is the first resistance pattern.

The pulse output unit may be configured to output the discharge pulse at a discharge start point where discharge of the battery begins.

The initial discharge region may be preset as a region from a discharge start point where discharge of the battery begins to a target point.

The target point may be preset as a point corresponding to a minimum resistance value from the start point in a criterion profile preset to correspond to the battery.

The control unit may be configured to calculate the resistance value of the battery at each predetermined cycle based on a current amount corresponding to the discharge pulse and the voltage deviation.

A battery pack according to another aspect of the present disclosure may comprise the apparatus for diagnosing a battery according to one aspect of the present disclosure.

A vehicle according to still another aspect of the present disclosure may comprise the apparatus for diagnosing a battery according to one aspect of the present disclosure.

A method for diagnosing a battery according to still another aspect of the present disclosure may comprise a voltage measuring step of measuring a voltage of a battery during a discharge process of the battery; a discharge pulse output step of generating a discharge pulse at every predetermined cycle and outputting the generated discharge pulse to the battery; a resistance value calculating step of calculating a resistance value of the battery based on a voltage deviation of the battery due to the discharge pulse; a resistance pattern determining step of determining a resistance pattern in a preset initial discharge region based on the calculated resistance value; and a diagnosing step of judging whether there is lithium precipitation in the battery according to the determined resistance pattern.

### Advantageous Effects

According to one aspect of the present disclosure, the apparatus for diagnosing a battery has an advantage of diagnosing the state of the battery based on the resistance change rate of the battery in the initial discharge region. In other words, the apparatus for diagnosing a battery has an advantage of quickly diagnosing lithium precipitation in the battery by calculating the resistance value at the initial discharge point of the battery.

In addition, according to one aspect of the present disclosure, since the diagnosis is performed in the discharge process of the battery, that is, the diagnosis is performed in the process of reducing the battery's energy, there is an advantage in that lithium precipitation in the battery can be safely diagnosed.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating an apparatus for diagnosing a battery according to an embodiment of the present disclosure.
FIG. 2 is a diagram schematically illustrating a discharge pulse according to an embodiment of the present disclosure.
FIG. 3 is a diagram schematically showing a criterion profile and a resistance profile of a first battery according to an embodiment of the present disclosure.
FIG. 4 is an enlarged view showing the area S1 in FIG. 3.
FIG. 5 is a diagram schematically showing a criterion profile and a resistance profile of a second battery according to an embodiment of the present disclosure.
FIG. 6 is an enlarged view showing the area S2 in FIG. 5.
FIG. 7 is a diagram schematically showing an exemplary configuration of a battery pack according to another embodiment of the present disclosure.
FIG. 8 is a diagram schematically showing a vehicle according to still another embodiment of the present disclosure.
FIG. 9 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

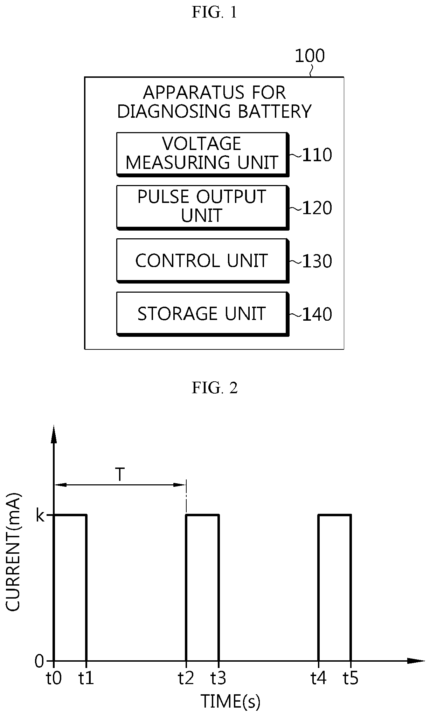

FIG. 1 is a diagram schematically illustrating an apparatus 100 for diagnosing a battery according to an embodiment of the present disclosure.

Referring to FIG. 1, the apparatus 100 for diagnosing a battery may include a voltage measuring unit 110, a pulse output unit 120, and a control unit 130.

Here, the battery means one physically separable independent cell having a negative electrode terminal and a positive electrode terminal. For example, a lithium-ion battery or a lithium polymer battery may be regarded as a battery. In addition, the battery may mean a battery module in which a plurality of cells are connected in series and/or parallel. Hereinafter, for convenience of description, a battery will be described as meaning one independent cell.

The voltage measuring unit 110 may be configured to measure the voltage of the battery during the discharge process of the battery.

Specifically, the voltage measuring unit 110 may measure the voltage of the battery in the discharge process of the battery at each voltage measurement cycle.

The pulse output unit 120 may be configured to generate a discharge pulse at every predetermined cycle.

Specifically, the pulse output unit 120 may be configured to generate a discharge pulse at every predetermined cycle when receiving a pulse generation signal from the control unit 130. Also, when the pulse output unit 120 receives a pulse generation end signal from the control unit 130, the pulse output unit 120 may stop generating discharge pulses.

For example, the pulse output unit 120 may generate a DC pulse (Direct current pulse) at every predetermined cycle. As another example, the pulse output unit 120 may generate an AC pulse (Alternating current pulses) at every predetermined cycle.

The pulse output unit 120 may be configured to output the generated discharge pulse to the battery.

Specifically, the pulse output unit 120 may output a discharge pulse to the negative electrode of the battery through the pulse line PL. More specifically, the pulse output unit 120 may output a discharge pulse to the negative electrode of the battery to correspond to the discharge direction of the battery.

Preferably, the pulse output unit 120 may be configured to output a discharge pulse at a discharge start point where discharge of the battery begins. For example, the pulse output unit 120 may output a discharge pulse at the same time that the battery starts discharging. In other words, since the change in the internal state of the battery can be diagnosed from the discharge start point, the battery state diagnosis result can be a highly reliable result that better reflects the state of the battery.

FIG. 2 is a diagram schematically illustrating a discharge pulse according to an embodiment of the present disclosure.

Referring to FIG. 2, the pulse output unit 120 may generate and output a discharge pulse with a current value of k [mA] at every predetermined cycle T. The discharge pulse generated by the pulse output unit 120 may be the same. In other words, the current amount of the discharge pulse may be the same. For example, the pulse output unit 120 may output a discharge pulse of 0.1 seconds at every minute. In other words, the predetermined cycle T in which the discharge pulse is output may be 1 minute, and a discharge pulse of 0.1 seconds may be output at each cycle.

In addition, in the embodiment of FIG. 2, t0 at which discharge pulses begin to be output may be the same as the time when discharge of the battery begins. In other words, the pulse output unit 120 may output a discharge pulse at the time point t0 when the battery begins to discharge. Therefore, battery discharge and discharge pulse output can begin simultaneously.

The control unit 130 may be configured to calculate the resistance value of the battery based on the voltage deviation of the battery caused by the discharge pulse.

Specifically, the control unit 130 may calculate the internal resistance value of the battery based on the discharge pulse applied to the battery being discharged.

Preferably, the control unit 130 may be configured to calculate the resistance value of the battery at each predetermined cycle based on the current amount corresponding to the discharge pulse and the voltage deviation.

Referring to FIG. 2, the current amount of the discharge pulse can be calculated in the same way. For example, assuming that the time at which the discharge pulse is applied is △t, the current amount of the discharge pulse can be calculated as "k × △t". Here, △t may be the time difference between t0 and t1, t2 and t3, or t4 and t5. Assuming that the pulse output unit 120 outputs a discharge pulse of 0.1 seconds at every minute, △t may be 0.1 seconds, and T may be 60 seconds.

Additionally, the control unit 130 may calculate the voltage deviation of the battery according to the discharge pulse by calculating the difference between the voltage of the battery at the start point of the discharge pulse and the voltage of the battery at the end point of the discharge pulse. For example, in the embodiment of FIG. 2, the control unit 130 may calculate the voltage deviation by calculating the difference between the voltage of the battery at time t0 and the voltage of the battery at time 11.

Lastly, the control unit 130 may calculate the resistance value of the battery from the current amount and the voltage deviation using Ohm's law. For example, the control unit 130 may calculate the resistance value by calculating "R = △V ÷ △I". Here, R may be the resistance value, △V may be the voltage deviation, and △I may be the current amount.

The control unit 130 may be configured to determine a resistance pattern in a preset initial discharge region based on the calculated resistance value.

Specifically, the control unit 130 may calculate a plurality of resistance values while the battery is being discharged. Additionally, the initial discharge region may include a plurality of resistance values calculated by the control unit 130. Here, the initial discharge region refers to the time interval from the discharge start point to a predetermined time. Specific details about the initial discharge region will be described later.

More specifically, the control unit 130 may be configured to calculate the resistance change rate for the plurality of target resistance values included in the initial discharge region. Here, the target resistance value may refer to a resistance value belonging to the initial discharge region among the plurality of resistance values calculated by the control unit 130.

For example, the control unit 130 may be configured to calculate an average change rate for the plurality of target resistance values included in the initial discharge region. Additionally, the control unit 130 may be configured to calculate the calculated average change rate as the resistance change rate.

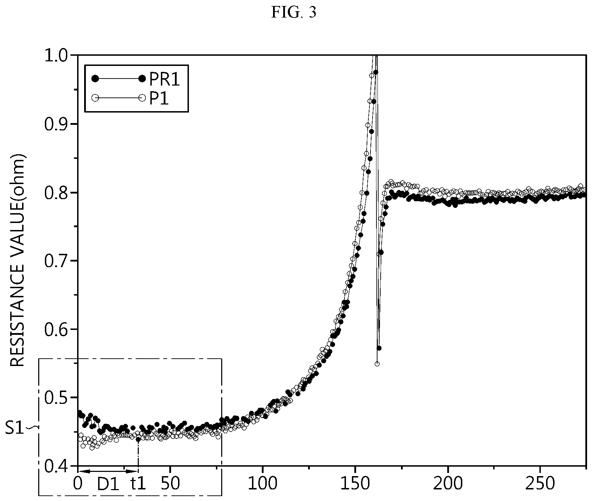

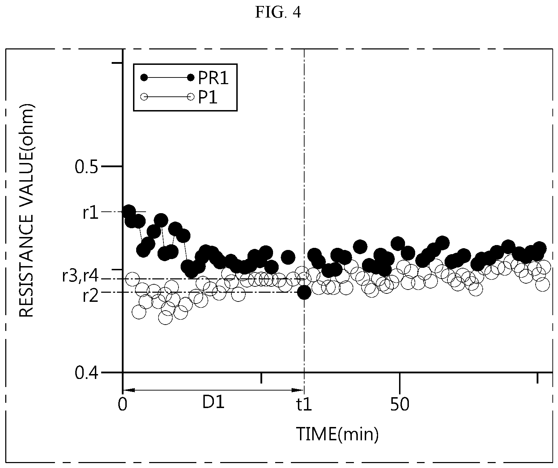

FIG. 3 is a diagram schematically showing a criterion profile PR1 and a resistance profile P1 of a first battery according to an embodiment of the present disclosure. Also, FIG. 4 is an enlarged view showing the area S1 in FIG. 3. Specifically, the area S1 may be an enlarged view of a partial area in the criterion profile PR1 and the resistance profile P1.

First, the criterion profile PR1 and the resistance profile P1 may be profiles representing the correspondence between resistance value and time. Specifically, the criterion profile PR1 may be a preset profile for the first battery in a BOL (Beginning of life) state or a criterion battery for the first battery. Also, the resistance profile P1 may be a profile created by the control unit during the discharge process of the first battery. That is, the resistance profile P1 may be a profile showing the resistance value calculated by the control unit over time.

In the embodiment of FIG. 3, the control unit 130 may calculate the resistance value of the first battery at every predetermined cycle T during the discharge process of the first battery. Additionally, the control unit 130 may calculate the average change rate in the initial discharge region D1. Specifically, the control unit 130 may calculate the resistance value change rate according to time at the initial discharge point (0 seconds) and time 11.

For example, in the embodiment of FIG. 4, the control unit 130 may calculate the resistance change rate for the first battery by calculating the formula "(r4 - r3) ÷ (t1 - 0)". Here, since r3 and r4 are the same, the resistance change rate for the first battery may be 0.

The control unit 130 may be configured to compare the calculated resistance change rate with a preset criterion change rate.

The control unit 130 may compare the magnitude between the calculated resistance change rate and the preset criterion change rate. That is, the control unit 130 may determine whether the calculated resistance change rate is less than or more than the criterion change rate.

Here, the criterion change rate is a resistance change rate that is a criterion for determining the resistance pattern of the battery, and may be set in advance. For example, the criterion change rate may be preset to 0. As another example, the criterion change rate may be preset to any value in the range of 0 or more and less than the resistance change rate according to the criterion profile PR1. In the embodiment of FIG. 4, the criterion change rate may be preset to "0" or "any one value greater than 0 and less than (r2 - r1) ÷ (t1 - 0)." Here, "(r2 - r1) ÷ (t1 - 0)" is the resistance change rate for the first resistance profile PR1.

The control unit 130 may be configured to determine the resistance pattern as a first resistance pattern or a second resistance pattern based on the comparison result. Preferably, the control unit 130 may be configured to determine the resistance pattern as the first resistance pattern if the calculated resistance change rate is less than the criterion change rate. Conversely, the control unit 130 may be configured to determine the resistance pattern as the second resistance pattern if the calculated resistance change rate is greater than or equal to the criterion change rate.

For example, in the embodiments of FIGS. 3 and 4, it is assumed that both the calculated resistance change rate and the criterion change rate are 0. Since the resistance change rate is greater than the criterion change rate, the control unit 130 may determine the resistance pattern of the first battery as the second resistance pattern.

The control unit 130 may be configured to judge whether there is lithium precipitation in the battery according to the determined resistance pattern.

For example, the control unit 130 may be configured to diagnose that lithium precipitation has occurred in the battery if the resistance pattern is the first resistance pattern. Conversely, the control unit 130 may diagnose that lithium has not been precipitated in the battery if the resistance pattern is the second resistance pattern.

For example, in the embodiments of FIGS. 3 and 4, it is assumed that the resistance pattern of the first battery is determined as the second resistance pattern. Therefore, the control unit 130 may diagnose that lithium metal is not precipitated in the first battery.

The apparatus 100 for diagnosing a battery according to an embodiment of the present disclosure has an advantage of diagnosing the state of the battery based on the resistance change rate of the battery in the initial discharge region. In other words, the apparatus 100 for diagnosing a battery has an advantage of quickly diagnosing lithium precipitation in the battery by calculating the resistance value at the initial discharge point of the battery. In addition, because the diagnosis is performed during the discharge process of the battery, that is, during the process in which the energy of the battery is reduced, there is an advantage that lithium precipitation in the battery can be safely diagnosed.

Meanwhile, the control unit 130 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the apparatus 100 for diagnosing a battery may further include a storage unit 140. The storage unit 140 may store data necessary for operation and function of each component of the apparatus 100 for diagnosing a battery, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

The criterion profile and the criterion change rate corresponding to the battery may be stored in advance in the storage unit 140. Additionally, the control unit 130 may access the storage unit 140 to obtain the criterion profile and the criterion change rate. Additionally, the voltage value measured by the voltage measuring unit 110 may be stored in the storage unit 140.

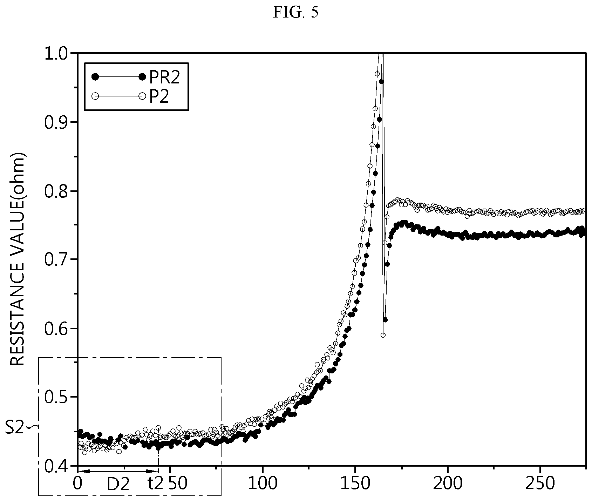

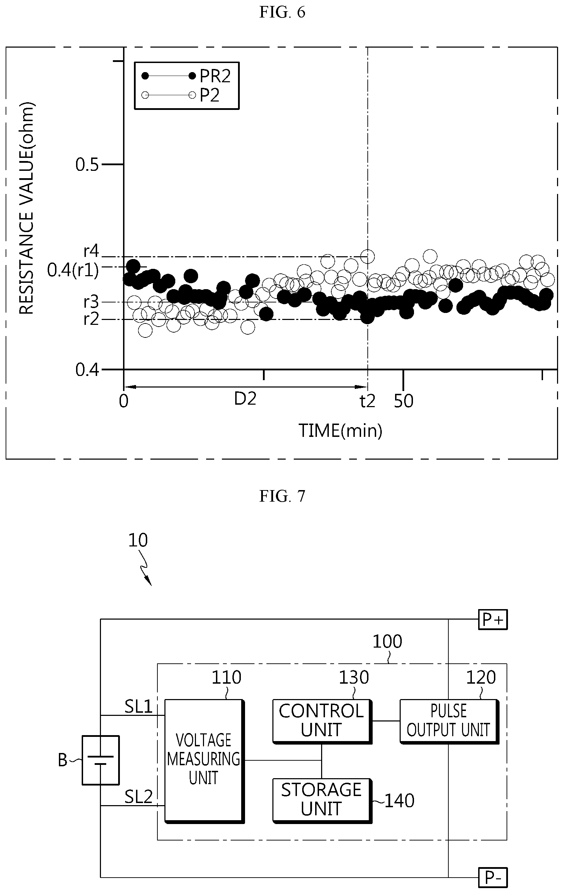

Hereinafter, with reference to FIGS. 5 and 6, an embodiment in which the apparatus 100 for diagnosing a battery diagnoses the state of a second battery will be described.

FIG. 5 is a diagram schematically showing a criterion profile PR2 and a resistance profile P2 of a second battery according to an embodiment of the present disclosure. FIG. 6 is an enlarged view showing the area S2 in FIG. 5. Specifically, the area S2 may be an enlarged view of a partial area of the criterion profile PR2 and the resistance profile P2.

For example, in the embodiment of FIG. 6, the control unit 130 may calculate the resistance change rate for the second battery by calculating the formula "(r4 - r3) ÷ (t2 - 0)". Here, because r4 is greater than r3, the resistance change rate for the second battery can be calculated as a positive number. If the criterion change rate for the second battery is set to 0, the calculated resistance change rate may be greater than the criterion change rate. Therefore, the control unit 130 may determine the resistance pattern for the second battery as the second resistance pattern based on the comparison result. Also, the control unit 130 may diagnose that lithium is not precipitated in the second battery based on the determined resistance pattern.

Hereinafter, the initial discharge region set to correspond to each battery will be described in detail.

The initial discharge region can be set in advance from the discharge start point where battery discharge begins, to the target point.

For example, in the embodiment of FIG. 3, the first initial discharge region D1 for the first battery may be preset to 0 to t1. Also, in the embodiment of FIG. 5, the second initial discharge region D2 for the second battery may be preset to 0 to t2.

That is, because the initial discharge region represents a time interval for diagnosing the state of the battery, it can be independently set to correspond to the battery. If the initial discharge region is set uniformly without considering the type of battery, etc., the battery resistance change rate indicated in the initial discharge region may not accurately represent the state of the battery. Therefore, the initial discharge region can be set to correspond to each battery.

Specifically, the target point may be preset from the start point to the time point corresponding to the minimum resistance value in the criterion profile preset to correspond to the battery.

For example, in the embodiment of FIG. 3, the target point may be t1. Referring to the enlarged view of FIG. 4, in the first criterion profile PR1, the resistance value at the discharge start point (0 seconds) may be r1, and the minimum resistance value may be r2. Therefore, the target point may be 11, which is the time point corresponding to the minimum resistance value r2. Also, the initial discharge region D1 for the first battery may be the time interval from the discharge start point (0 seconds) to the target point t1. In other words, lithium precipitation in the first battery can be seen best in the time from 0 seconds to t1 seconds. Therefore, the control unit 130 can more accurately diagnose whether there is lithium precipitation in the first battery according to the resistance change rate of the first battery in the initial discharge region D1.

As another example, in the embodiment of FIG. 5, the target point may be t2. Referring to the enlarged view of FIG. 6, in the second criterion profile PR2, the resistance value at the discharge start point (0 seconds) may be r1, and the minimum resistance value may be r2. Therefore, the target point may be t2, which is the time point corresponding to the minimum resistance value r2. Also, the initial discharge region D2 for the second battery may be the time interval from the discharge start point (0 seconds) to the target point t2. In other words, lithium precipitation in the second battery can be seen best in the time from 0 seconds to t2 seconds. Therefore, the control unit 130 can more accurately diagnose whether there is lithium precipitation in the second battery according to the resistance change rate of the second battery in the initial discharge region D2.

The apparatus 100 for diagnosing a battery according to an embodiment of the present disclosure can accurately diagnose lithium precipitation in the battery according to the resistance change rate in the initial discharge region set for each battery. In other words, since the initial discharge region in which lithium precipitation can be accurately diagnosed can be set for each battery according to the resistance change rate of the battery at the beginning of discharge, the apparatus 100 for diagnosing a battery has an advantage of more accurately diagnosing lithium precipitation in the battery. In addition, since lithium precipitation can be immediately diagnosed according to the resistance change rate at the beginning of discharge, there is an advantage that the state of the battery can be quickly diagnosed.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the voltage measuring unit 110, the pulse output unit 120, the control unit 130 and the storage unit 140 of the apparatus 100 for diagnosing a battery may be implemented as components of the BMS.

In addition, the apparatus 100 for diagnosing a battery according to the present disclosure may be provided to a battery pack. That is, the battery pack according to the present disclosure may include the above-described apparatus 100 for diagnosing a battery and one or more battery cells. In addition, the battery pack may further include electrical components (a relay, a fuse and the like) and a case.

FIG. 7 is a diagram schematically showing an exemplary configuration of a battery pack according to another embodiment of the present disclosure.

The positive electrode terminal of the battery B may be connected to the positive electrode terminal P+ of the battery pack 10, and the negative electrode terminal of the battery B may be connected to the negative electrode terminal P- of the battery pack 10.

The voltage measuring unit 10 may be connected to the first sensing line SL1 and the second sensing line SL2. Specifically, the voltage measuring unit 110 may be connected to the positive electrode terminal of the battery B through the first sensing line SL1, and may be connected to the negative electrode terminal of the battery B through the second sensing line SL2. The voltage measuring unit 110 may measure the voltage of the battery B based on the voltage measured at each of the first sensing line SL1 and the second sensing line SL2.

For example, the voltage measuring unit 110 may measure the voltage of the battery B while the battery B is being discharged. Here, the voltage measuring unit 110 may measure the voltage of the battery B even while a discharge pulse is applied to the battery B by the pulse output unit 120. Additionally, the control unit 130 may calculate the resistance value of the battery B based on the voltage deviation of the battery B due to the discharge pulse.

Meanwhile, one end of the load (not shown) may be connected to the positive electrode terminal P+ of the battery pack 10, and the other end may be connected to the negative electrode terminal P- of the battery pack 10. Accordingly, the positive electrode terminal of the battery B, the positive electrode terminal P+ of the battery pack 10, the load, the negative electrode terminal P- of the battery pack 10, and the negative electrode terminal of the battery B can be electrically connected. For example, the load may be a charging and discharging device, or a motor of an electric vehicle or the like that receives power from the battery B.

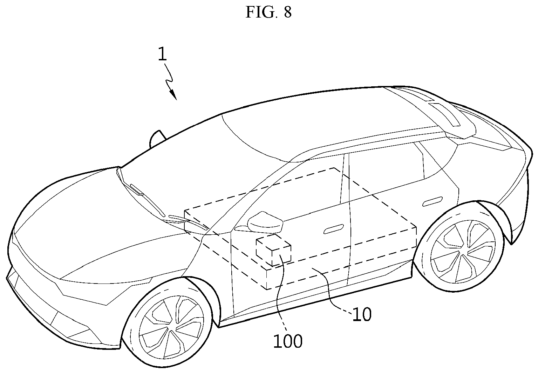

FIG. 8 is a diagram schematically showing a vehicle 1 according to still another embodiment of the present disclosure.

Referring to FIG. 8, the apparatus for diagnosing a battery 100 according to an embodiment of the present disclosure may be included in a vehicle 1 such as an electric vehicle (EV) or a hybrid vehicle (HV). In addition, the apparatus for diagnosing a battery 100 may be included in the battery pack 10, and the battery pack 10 may be included in the vehicle 1. In addition, the battery pack may drive the vehicle 1 by supplying power to a motor through an inverter included in the vehicle 1.

For example, when the battery pack 10 included in the vehicle 1 is discharged, the apparatus 100 for diagnosing a battery can diagnose lithium precipitation in the battery cells included in the battery pack by outputting a discharge pulse. In other words, since the battery state can be diagnosed even without a separate maintenance process, there is an advantage in that the battery state can be checked at any time. Also, if it is diagnosed that lithium has been precipitated in the battery, information about this can be provided immediately.

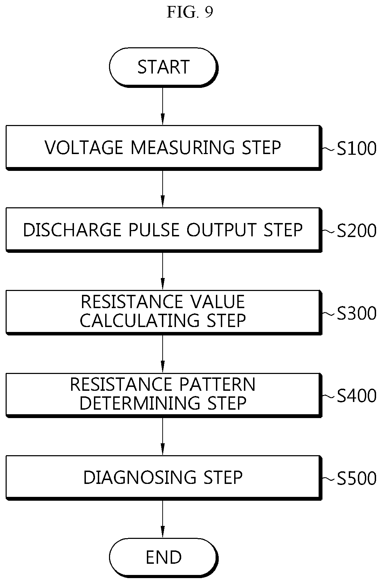

FIG. 9 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be omitted or briefly described.

Referring to FIG. 9, the method for diagnosing a battery may include a voltage measuring step (S100), a discharge pulse output step (S200), a resistance value calculating step (S300), a resistance pattern determining step (S400), and a diagnosing step (S500). In the embodiment of FIG. 9, the discharge pulse output step (S200) is shown as being performed after the voltage measuring step (S100), but preferably, the voltage measuring step (S100) and the discharge pulse output step (S200) may be performed simultaneously.

The voltage measuring step (S 100) is a step of measuring the voltage of the battery in the discharge process of the battery, and may be performed by the voltage measuring unit 110.

The discharge pulse output step (S200) is a step of generating a discharge pulse at every predetermined cycle and outputting the generated discharge pulse to the battery, and may be performed by the pulse output unit 120.

For example, the voltage measuring unit 110 may measure the voltage of the battery during the discharge process of the battery. Preferably, the voltage measuring unit 110 may measure the voltage of the battery even when a discharge pulse is applied to the battery. Here, it is desirable that the output cycle T of the discharge pulse is preset to be equal to or greater than the voltage measurement cycle of the voltage measuring unit 110.

The resistance value calculating step (S300) is a step of calculating the resistance value of the battery based on the voltage deviation of the battery due to the discharge pulse, and may be performed by the control unit 130.

For example, the control unit 130 can know information about the discharge pulse in advance. That is, the control unit 130 can know the current amount (△I) of the discharge pulse in advance. Therefore, the control unit 130 can calculate the resistance value R of the battery by considering the current amount (△I) and the voltage deviation (△V) of the battery according to the discharge pulse.

The resistance pattern determining step (S400) is a step of determining the resistance pattern in a preset initial discharge region based on the calculated resistance value, and may be performed by the control unit 130.

The control unit 130 may calculate the resistance change rate by calculating an average change rate for a plurality of target resistance values included in the initial discharge region. Additionally, the control unit 130 may compare the calculated resistance change rate with a preset criterion change rate to determine the resistance pattern.

For example, if the calculated resistance change rate is less than the criterion change rate, the control unit 130 may determine the resistance pattern as the first resistance pattern. Conversely, the control unit 130 may determine the resistance pattern as the second resistance pattern if the calculated resistance change rate is greater than or equal to the criterion change rate.

The diagnosing step (S500) is a step of judging whether or not there is lithium precipitation in the battery according to the determined resistance pattern, and may be performed by the control unit 130.

For example, the control unit 130 may be configured to diagnose that lithium precipitation has occurred in the battery if the resistance pattern is the first resistance pattern. Conversely, the control unit 130 may diagnose that lithium has not been precipitated in the battery if the resistance pattern is the second resistance pattern.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: vehicle
10: battery pack
100: apparatus for diagnosing a battery
110: voltage measuring unit
120: pulse output unit
130: control unit
140: storage unit

## Claims

1. An apparatus for diagnosing a battery, comprising:
a voltage measuring unit configured to measure a voltage of a battery during a discharge process of the battery;
a pulse output unit configured to generate a discharge pulse at every predetermined cycle and output the generated discharge pulse to the battery; and
a control unit configured to calculate a resistance value of the battery based on a voltage deviation of the battery due to the discharge pulse, determine a resistance pattern in a preset initial discharge region based on the calculated resistance value, and diagnose whether there is lithium precipitation in the battery according to the determined resistance pattern.

2. The apparatus for diagnosing a battery according to claim 1,
wherein the control unit is configured to calculate a resistance change rate for a plurality of target resistance values included in the initial discharge region, compare the calculated resistance change rate with a preset criterion change rate, and determine the resistance pattern as a first resistance pattern or a second resistance pattern based on the comparison result.

3. The apparatus for diagnosing a battery according to claim 2,
wherein the control unit is configured to calculate an average change rate for the plurality of target resistance values included in the initial discharge region, and calculate the calculated average change rate as the resistance change rate.

4. The apparatus for diagnosing a battery according to claim 2,
wherein when the calculated resistance change rate is less than the criterion change rate, the control unit is configured to determine the resistance pattern as the first resistance pattern, and
wherein when the calculated resistance change rate is equal to or greater than the criterion change rate, the control unit is configured to determine the resistance pattern as the second resistance pattern.

5. The apparatus for diagnosing a battery according to claim 2,
wherein the control unit is configured to diagnose that lithium has been precipitated in the battery when the resistance pattern is the first resistance pattern.

6. The apparatus for diagnosing a battery according to claim 1,
wherein the pulse output unit is configured to output the discharge pulse at a discharge start point where discharge of the battery begins.

7. The apparatus for diagnosing a battery according to claim 1,
wherein the initial discharge region is preset as a region from a discharge start point where discharge of the battery begins to a target point.

8. The apparatus for diagnosing a battery according to claim 7,
wherein the target point is preset as a point corresponding to a minimum resistance value from the start point in a criterion profile preset to correspond to the battery.

9. The apparatus for diagnosing a battery according to claim 1,
wherein the control unit is configured to calculate the resistance value of the battery at each predetermined cycle based on a current amount corresponding to the discharge pulse and the voltage deviation.

10. A battery pack, comprising the apparatus for diagnosing a battery according to any one of claims 1 to 9.

11. A vehicle, comprising the apparatus for diagnosing a battery according to any one of claims 1 to 9.

12. A method for diagnosing a battery, comprising:
a voltage measuring step of measuring a voltage of a battery during a discharge process of the battery;
a discharge pulse output step of generating a discharge pulse at every predetermined cycle and outputting the generated discharge pulse to the battery;
a resistance value calculating step of calculating a resistance value of the battery based on a voltage deviation of the battery due to the discharge pulse;
a resistance pattern determining step of determining a resistance pattern in a preset initial discharge region based on the calculated resistance value; and
a diagnosing step of judging whether there is lithium precipitation in the battery according to the determined resistance pattern.
